Europäisches Patentamt

(19) **European Patent Office**

**Office européen des brevets**

(11) Publication number: **0 114 197**
**A2**

(12) # EUROPEAN PATENT APPLICATION

(21) Application number: **83110308.0**

(22) Date of filing: **17.10.83**

(51) Int. Cl.³: **H 03 K 13/24**

(30) Priority: **23.12.82 US 452684**

(43) Date of publication of application:
**01.08.84 Bulletin 84/31**

(84) Designated Contracting States:
**DE FR GB IT NL**

(71) Applicant: **International Business Machines Corporation**
**Old Orchard Road**
**Armonk, N.Y. 10504(US)**

(72) Inventor: **Nassimbene, Ernie George**
**109 El Altillo**
**Los Gatos California 95030(US)**

(74) Representative: **Lancaster, James Donald**
**IBM United Kingdom Patent Operations Hursley Park**
**Winchester, Hants, S021 2JN(GB)**

(54) **Electro-optical keyboard apparatus.**

(57) A keyboard comprising a plurality of key assemblies (10) having a key lever (12) pivoting at one end (11), having a key button (16) attached, and having a code flag member (20) attached by flexible means to the opposite end of the key levers. The code flag members have bar coded indicia (40) and include an end portion (24) which engages a striker bar (14) when the key lever is depressed to flex the flexible means so that the code flag member is moved into a position adjacent to a sensing means (22) which includes a light beam (28) directed to a single photodetector (30). When fully depressed the end portion (24) slips off the striker bar (14) so that the code flag member "snaps" through the sensing assembly (22) thereby producing a series of pulses by the photodetector corresponding to the coded indicia for the actuated key assembly. When the actuated key assembly is manually released, the code flag member returns on a different path which does not go through the sensing assembly.

FIG. 1

0114197

ELECTRO-OPTICAL KEYBOARD APPARATUS

DESCRIPTION

## Background of the Invention

### Field of the Invention

This invention relates to a keyboard and more particularly to a keyboard for producing encoded electrical signals in response to manually keyed data entry operations.

### Description of the Prior Art

There has been a requirement for encoded electrical signals in response to manually keyed data entry operations for typewriters, other office machines and data processing systems. One type of keyboard which has been developed to meet this requirement is an electro-optical keyboard.

An early example of an electro-optical keyboard is described in U.S. patent 2,408,754 to Bush in which a series of seven light beams are selectively interrupted by coded shutters attached to typewriter key levers. Each of the first six light beams controls an associated photoelectric cell which represents one element of the six-unit code. The seventh light beam is interrupted when each key is depressed and serves as an interlock to prevent a second code signal from being sent prior to the time the key which produced the first code signal is restored.

The requirement that one key be completely restored to its unactuated position before another key can be depressed has caused some problems since this operation produces a different "feel" to those persons familiar with the touch of ordinary manual or electric typewriters. Various attempts have been made to improve the operation of keyboards with respect to these characteristics. One such attempt in U.S. patent 3,507,995 to Gianni et al permitted independent key return operation after a predetermined amount of keystroke travel. U.S. patent 3,603,982 to Patti permitted the interlock function to be performed electronically, and U.S. patent 3,750,150 to Cramer et al provided the possibility of limited keying overlap by utilizing code shutters having a predetermined light attenuation factor in conjunction with several threshold switches within the sensor circuitry.

A further improvement was disclosed in U.S. patent 4,159,183 in which the actuation of a key moves code elements into the path of a photoelectric sensing system in a path so that the code elements traverse the sensing system path only once. However this keyboard apparatus still requires seven photocells for sensing and requires complex parts to perform the described operation.

No prior art known to applicant suggests an electro-optical keyboard which uses only a single photocell and light for the entire keyboard. This arrangement gives a significant advantage in terms of reduced complexity of not only the mechanical parts but also the electronic control circuits.

Summary of the Invention

The main advantage of the invention as claimed is that only one low cost detector is required for the entire keyboard. A supplementary advantage of the invention as claimed is that each key generates the desired machine language code when the key is depressed.

According to the invention, an electro-optical keyboard is provided which includes an optical assembly in fixed position within the keyboard. The optical assembly comprises a light source and a single photodetector to receive a light beam from the light source. A plurality of key assemblies include an articulate portion positioned to pass through the light beam when the key assembly is actuated. The articulate portion contains optically encoded indicia individually

0114197

coded to correspond to the host key assembly so that coded signals are produced by the single photodetector corresponding to the individual code for the actuated key assembly as the articulate portion passes through the light beam.

The foregoing and other objects, features and advantages of the invention will be apparent from the following more particular description of a preferred embodiment of the invention as illustrated in the accompanying drawings.

## Brief Description of the Drawing

An electro-optical keyboard embodying the invention will now be described by way of example with reference to the accompanying drawing wherein:

FIG. 1 is a perspective view, partially broken away, of the keyboard embodying the invention;

FIG. 2 is a section view along lines 2-2 of FIG. 1 showing the key assembly in the rest or unactuated position;

FIG. 3 is a section view along lines 2-2 of FIG. 1 showing the key assembly in a partially actuated position;

FIG. 4 is a section view along lines 4-4 of FIG. 1;

FIG. 5 is a section view along lines 5-5 of FIG. 4;

FIG. 6 is a perspective view of an alternate embodiment of a portion of the invention;

FIG. 7 is a perspective view, partially broken away, of an alternate embodiment of the keyboard embodying the invention;

FIG. 8 is a schematic block diagram of the electronic control circuits associated with the keyboard of FIG. 1.

## Description of the Preferred Embodiment

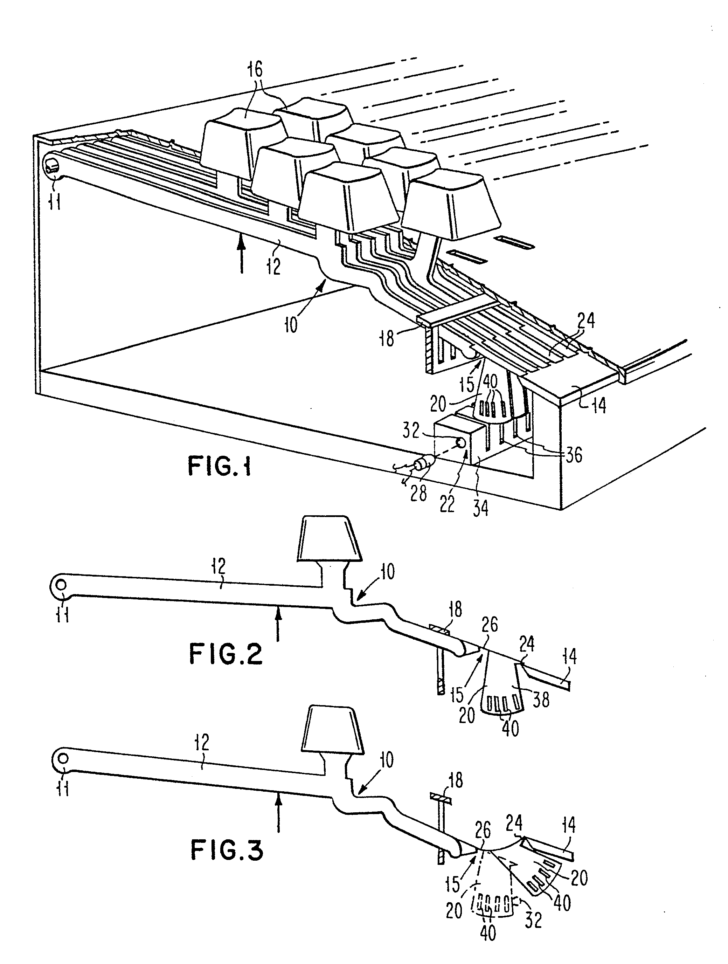

As illustrated in FIG. 1, the keyboard embodying the invention comprises a plurality of key assemblies 10, each of which represents a particular character. Each of the key assemblies 10 comprises a key lever 12 which is fixed for pivotal movement at one end 11 and extends to an articulate portion 15 positioned over a striker bar 14 at the opposite end. A key button 16 is provided on each key lever 12, and the key buttons 16 can be arranged in a plurality of rows in a standard keyboard configuration, if desired. The key levers 12 are lightly spring biased so that the key levers 12 are positioned against stop member 18 in the rest or unactuated position.

The articulate portions 15 of key levers 12 are provided with a code flag member 20, which extends near a sensing assembly 22. The code flag member 20 is followed by an elongated end member 24 which extends over striker bar 14, and key lever 12 is provided with a selectively bendable spring section 26 in a part of key lever 12 which extends between code flag member 20 and key button 16. The components of key lever 12 are so proportioned and arranged that, when the key lever 12 is actuated, by manual pressure on the associated key button 16, the code flag member 20 moves through or past sensing assembly 22 only once as will be described in greater detail below. As the key lever 12 returns to its unactuated position, the code flag member does not go through the path which includes the sensing assembly 22.

The sensing assembly 22 comprises a light source 28 and a light detector 30 mounted at opposite ends of a collimated opening 32 in a sensing body member 34. Sensing body member 34 extends across the entire width of the keyboard, and sensing body member 34 includes a series of slots 36 positioned to receive the code flag member 20, with one slot 36 for each key assembly 10 of the keyboard.

The code flag members 20 comprise a flat thin section 38 having
suitable dimensions for moving into slots 36 during operation of the
keyboard as will be described in greater detail below.  Each of the
flat thin sections 38 include a series of detectable code indicia 40 in
the area which passes through slots 36.  The indicia 40 may comprise
slots or transparent areas in a material that is opaque to the light
from source 28 or opaque areas in a material that is transparent to the
light from source 28.  The indicia 40 are in a number and arrangement
to represent the character defined by the associated key lever 12 in a
chosen code so that a unique arrangement of code indicia 40 is provided
for each key lever 12 in the keyboard.

As can be seen more clearly in FIG. 2, the key lever 12 is initially
positioned in its unactuated position in contact with stop member 18,
with end member 24 extending over striker bar 14, and with spring
section 26 unflexed.  When the key lever 12 is manually depressed, the
end member 24 moves down into engagement with striker bar 14 due to the
pivotal mounting at end 11 of key lever 12.  As the key lever 12 is
further depressed, spring section 26 starts flexing so that code flag
member 20 moves toward sensing assembly 22.  This action continues
until code flag member 20 is moved to a position adjacent to sensing
assembly 22 due to the continued flexing of spring section 26 as can be
seen in the full line drawing of FIG. 3.  Note that code flag member 20
is now positioned so that code indicia 40 can pass collimated opening
32 when code flag member 20 is released (next).

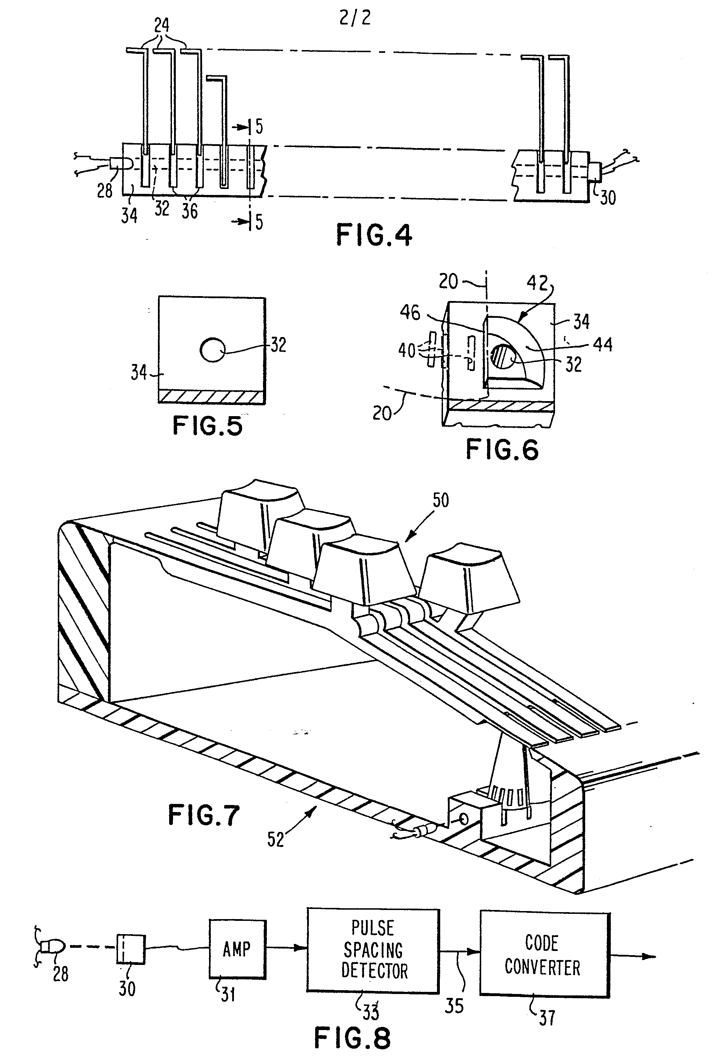

A slight further incremental movement causes end member 24 to slip off
striker bar 14 so that this action causes spring section 26 to "snap"
back to its normally straight position and further causes code flag
member 20 to pass through the sensing assembly 22 (see FIG. 4) to
produce the code for the actuated key.  The code is generated by
sensing the output of light detector 30.  Light detector 30 may
comprise any suitable light sensing device for detecting light from
light source 28, such as a photocell, for example, when light source 28
is an incandescent bulb.  The "snap" action of the code flag member 20 through the sensing assembly 22 produces a substantially constant rate of movement through the sensing assembly 22 regardless of how slowly or quickly the key button 16 is pushed down. This action permits a space dependent decoding to be used, such as the so-called delta-distance code described in U.S. patent 3,708,748. This coding technique utilizes a pair of reference pulses spaced apart by a known interval. A binary "one" is thereafter manifested by a pulse following at the same or similar interval and a binary "zero" is manifested as a pulse following at a different interval. Each of the code indicia 40 produces a pulse in the output of light detector 30, and this output is amplified by amplifier 31 (FIG. 8) and coupled to Pulse Spacing Detector circuit means 33. Detector circuit means 33 operates in the manner described above to produce binary coded data representing the character for the actuated key assembly 10. The binary coded data may be used directly or stored in a storage device 33 pending further usage.

The code indicia 40 on code flag members 20 can be provided to produce most codes directly. This code may be the widely used ASCII code or a particular typewriter code. In this case the desired code for the actuated key appears on line 35 with no further decoding required. In some cases it may not always be convenient to have the actual code on code flag member 20, or alternatively, it may be desirable to have different codes for the same key in different usage. In those cases the output of detector circuit means 33 on line 35 is coupled to a code converter circuit means 37 which is operable to convert the code on line 35 to the desired code for the actuated key assembly 10.

Note that the code flag member 20 ends up in the dotted position in FIG. 3, so that, when the key assembly 10 is released, the code flag member 20 does not go through the sensing assembly 22. This operation enables an operator to have more than one key depressed at the same time without having coding problems which would adversely affect the operation of the keyboard. The "snap" action produced when end member 24 is released from striker bar 14 provides the tactile feedback to the operator that the key has been properly actuated. These operational
factors make the keyboard adaptable for all uses including a
typewriter, a business machine or a data entry device for a data
processing system.

The key assemblies 10 and therefore the keyboard can be made more
compact by the addition of a stop member which prevents the code flag
member 20 from rebounding into the light path through sensing assembly
22 should any oscillation of code flag member 20 take place. As shown
in FIG. 6, the anti-rebound apparatus comprises a fixed stop member 42
positioned adjacent to collimated opening 32. Stop member 42 comprises
a tapered inclined angular face 44 with the thinnest end facing the
code flag member 20 and with thickness increasing as the stop member
extends to collimated opening 32. The stop member 42 terminates in a
substantially right angle face 46 just past collimated opening 32. In
operation, when end member 24 is released from striker bar 14 to
produce the "snap" action of code flag member 20 toward sensing
assembly 22, the code flag member 20 rides up the inclined face 44,
goes through sensing assembly 22, and is captured behind face 46. When
the associated key button 16 is released, spring section 26 is flexed
in the reverse direction due to the engagement of code flag member 20
with face 46. Code flag member 20 continues to be deflected by face 46
away from collimated opening 32 as the key lever is restored until code
flag member 20 is released from face 46 and restored to its unactuated
position.

The design of this keyboard is suitable for production with automated
techniques and at very low cost. One production technique suitable for
making the keyboard is by molding. The keyboard can be produced as a
two-piece, molded keyboard as is shown in FIG. 7. One piece 50
includes all the key assemblies and the code flag members, and the
other piece 52 includes the base member, the sensing assembly and the
striker bar. Alternatively, the base part of an existing keyboard can
be utilized with the code flag members 20 added to each key lever.

8         **0114197**

While the invention has been particularly shown and described with reference to a preferred embodiment thereof, it will be understood by those skilled in the art that various other changes in the form and details may be made therein without departing from the spirit and scope of the invention.

CLAIMS

1.  A keyboard having an optical coding assembly comprising

an optical assembly (22) in fixed position comprising means (28) for providing a light beam extending across said keyboard and a single photodetector (30) onto which the light beam impinges;

a plurality of key assemblies (10) across which the light beam is projected, each of said key assemblies comprising a key lever (12) pivoting at one end, having the other end terminated in an articulate portion (15), and having a key button (16) affixed thereto between the ends;

said articulate portion comprising an optical bar coded portion (20) individually coded to correspond to the host key assembly and positioned to pass through said light beam; and

means (14, 24) for restricting the passage of said coded portion through said light beam to but once for each actuation of the host key assembly so that coded signals are produced by said single photodetector corresponding to the individual code for the actuated key assembly.

2.  The keyboard of claim 1 additionally comprising

a striker bar fixed in a position extending across said key assemblies adjacent to said coded portions; and

each of said key levers being positioned to strike said striker bar in one direction of key lever travel so that the coded portion is deflected from its path of travel.

3.  The keyboard of claim 2 wherein said articulate portion is fitted with an elongated end member positioned for striking said striker bar for releasing the coded portion with snap action through the light beam.

4.  The keyboard of claim 3 additionally comprising a fixed stop means positioned to capture said coded portion after said coded portion is released through said light beam to prevent said coded portion from returning into said light beam as the host key assembly is restored to its unactuated position.

5. The keyboard of claim 1 wherein said articulate portion is an integral part of said key lever and wherein said articulate portion includes a section of reduced cross section sufficiently flexible to permit deflecting said coded portion through said light beam.

FIG.1

FIG.2

FIG.3

0114197

**FIG.4**

**FIG.5**

**FIG.6**

**FIG.7**

| 28 | 30 | AMP | PULSE SPACING DETECTOR | | CODE CONVERTER |
|---|---|---|---|---|---|

**FIG.8**